# EUROPEAN PATENT SPECIFICATION

(11) **EP 2 798 671 B1**
(45) Date of publication and mention of the grant of the patent: **22.04.2020**
(21) Application number: 12816614.7
(22) Date of filing: 28.12.2012
(51) Int. Cl.: H01L 21/683, B65G 49/06

(54) **VACUUM EFFECTOR AND METHOD OF USE**
VAKUUMEFFEKTOR UND VERWENDUNGSVERFAHREN
ACTIONNEUR DE VIDE ET SON PROCÉDÉ D'UTILISATION

(30) Priority: 30.12.2011 US 201161581986 P
(43) Date of publication of application: 05.11.2014
(73) Proprietor: 3M Innovative Properties Company, St. Paul, MN 55133-3427 (US)
(72) Inventor: LOPEZ, Waldo L., Saint Paul, Minnesota 55133-3427 (US); TAIT, Bruce E., Saint Paul, Minnesota 55133-3427 (US); ROSKA, Fred J., Saint Paul, Minnesota 55133-3427 (US); NEWHOUSE, Kevin B., Saint Paul, Minnesota 55133-3427 (US)
(74) Representative: Vossius & Partner Patentanwälte Rechtsanwälte mbB
(86) International application number: PCT/US2012/071978
(87) International publication number: WO 2013/102022

(56) References cited:
- DE-A1-102010 060 451
- GB-A- 2 264 479
- JP-A- 2004 259 792
- US-A- 3 910 620
- US-A- 5 203 905
- US-A1- 2010 065 696

## Description

### Field

The present invention relates to vacuum effectors, e.g., end effectors, for use in manipulating articles and methods of use.

### Background

Vacuum effectors employing negative pressure, sometimes referred to as end effectors or vacuum end effectors, are widely used to manipulate work pieces. Sometimes they are in the form of hand held tools, in other instances they are configured as the operating end of robotic limbs and similar devices. They are often used to eliminate the need to grip parts by hand, with hand tools, or with other compression devices, to reduce the potential for damaging errors, to automate repetitive tasks, and to automate precision tasks.

Some vacuum effectors employ negative pressure in the form of a vacuum and some vacuum effectors employ negative pressure generated by the Bernoulli effect. Illustrative examples of some known vacuum effectors are disclosed in US Patent Nos. 5,344,202 (Ramler et al.), 6,168,220 (Schmalz et al.), 6,341,769 (Lin et al.), 6,382,692 (Schmalz et al.), 6,425,565 (Montague), 6,601,888 (Mcllwraith et al.), 7,086,675 (Jacobs), 7,100,954 (Klein et al.), 7,216,821 (Reece et al.), 7,240,935 (Schmierer et al.), 7,309,089 (Perlman et al.) and 7,775,490 (Kawabata), and US Patent Appln. Publn. Nos. 2007/0023594 (Choi et al.) and 2007/0246621 (Akai et al.). Other examples include US5203905 and US3910620.

Some of the materials and articles which are desired to be manipulated, e.g., moved into other location and/or orientation, include delicate articles such as optical films, silicon chip wafers, etc. which when manipulated are easily subject to scratching and deformation, significantly degrading their value or even rendering them useless. A problem with currently available vacuum effectors is that such work pieces are highly susceptible to scratching and deformation, leading to unacceptable rates of waste or slow production.

The need exists for improved vacuum effectors.

### Summary

The present invention provides improved vacuum effectors and methods of use for manipulating work pieces. The vacuum effectors provided by the present invention are well suited for use with delicate, easily scratched articles or work pieces such as optical films, silicon chip wafers, etc.

In brief summary, vacuum effectors of the invention comprise: (a) a wall defining an enclosed opening and having a rim defining a lip plane; (b) a negative pressure source; and (c) a shroud as described herein covering the rim. In some embodiments, the vacuum effector further comprises a permeable support member spanning the enclosed opening and being recessed a selected depth from the lip plane

Briefly summarizing, the method of the invention comprises: (a) providing a vacuum effector as described herein, (b) providing a work piece, (c) engaging said vacuum effector with said work piece, and (d) disengaging said vacuum effector from said work piece.

### Brief Description of Drawing

The invention is further explained with reference to the drawing wherein:
Fig. 1 is a front view of a portion of one illustrative embodiment of a vacuum effector of the invention;
Fig. 2 is a cross section of the portion of vacuum effector shown in Fig. 1;
Fig. 3 is a cross section of an illustrative embodiment of the vacuum effector shown in Figs. 1 and 2; and
Fig. 4 is a cross section of another illustrative embodiment of the vacuum effector shown in Figs. 1 and 2.

These figures are not to scale and are intended to be merely illustrative and not limiting.

### Detailed Description of Illustrative Embodiments

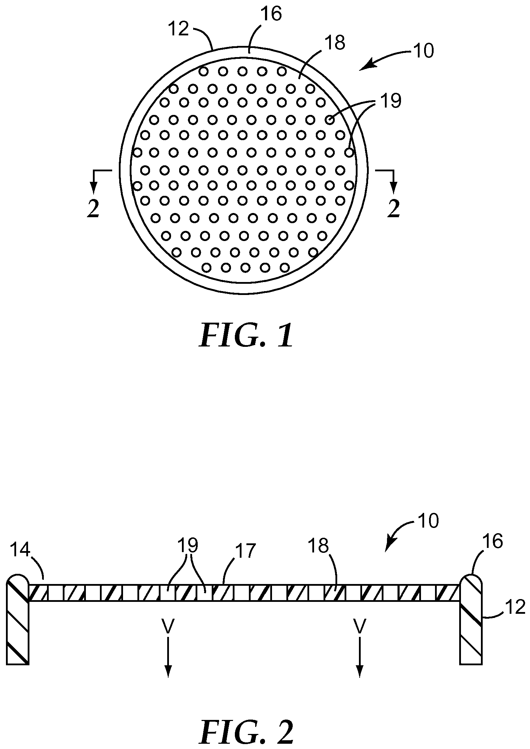

Figs. 1-4 show illustrative vacuum effectors 10 of the invention comprising: (a) a wall 12 defining an enclosed opening 14 and having a preferably continuous rim 16 defining a lip plane; (b) a negative pressure source (not shown) configured to exert a negative pressure (indicated by "V") that urges a workpiece (not shown) into contact with rim 16; (c) a shroud 20; and (d) optional permeable support member 18 spanning the enclosed opening, the support member having substantially planar face 17 that is recessed a selected depth from the lip plane with the face being in substantially parallel arrangement to the lip plane.

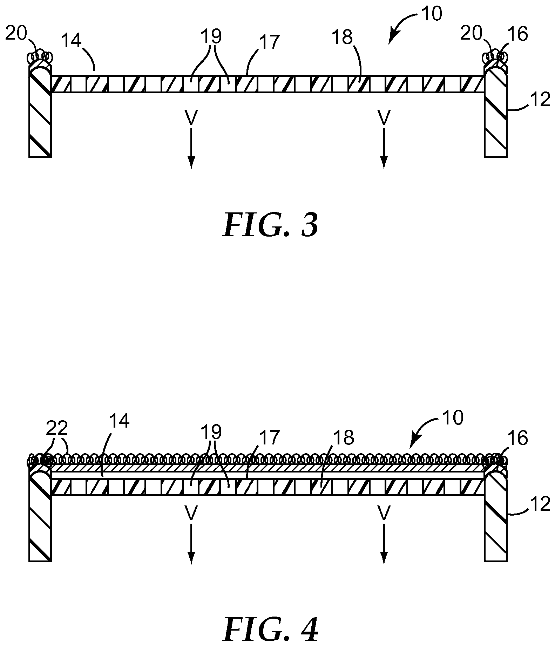

As shown in Fig. 3, in some embodiments shroud 20 covers rim 16 with enclosed opening 14 defined by wall 12. As shown in Fig. 4, in some other embodiments permeable shroud 22 covers rim 16 and spans enclosed opening 14.

Vacuum effectors of the invention can be made in a variety of sizes and configurations. They may be used individually, e.g., operating as separate units at the end of a robotic limb, as hand tools, etc., or if desired, they be configured in arrays of two or more vacuum effectors that are used simultaneously.

In many embodiments, as shown in Figs. 1-4, the enclosed opening is circular. As will be understood, enclosed openings of other shapes, e.g., ovals, rectangles, triangles, other regular geometries, and even irregular geometries, etc. may be used if desired.

Similarly, the perimeter outline of the wall, and accordingly the profile of the rim, may be circular or other shape as desired.

The dimensions and configuration of the enclosed opening will be no larger, and typically will be smaller, than the intended engagement location, i.e., "lifting location", on the work piece(s) being manipulated. In many instances, the work piece is substantially planar, e.g., sheets and chips of optical films. In some other instances, the work piece will be of more complex geometry but will preferably have a lifting location at which it can be engaged with a vacuum effector of the invention. The lifting location, which may, but need not, be a portion of the work piece that is less susceptible to damage, than other portions is preferably configured for engagement with the vacuum effector, e.g., is substantially planar, is configured for an effective seal with the vacuum effector, etc.

Vacuum effectors of the invention will be shaped and sized according to the intended application. For instance, effectors with circular enclosed openings having diameters from about 2 to about 20 centimeters may be typical. Typically, enclosed openings having areas within the range of about 2 centimeter² to about 1500 centimeter² will be used. It will be understood, however, that vacuum effectors with enclosed openings outside this range may be used if desired.

In preferred embodiments, the rim comprises a resilient, compressible material to facilitate development of a secure engagement to the work piece.

The wall and other components of the assembly should be sufficiently strong and durable to withstand the mechanical loads and stresses encountered during use. For instance, as the vacuum effector is used repeatedly, the assembly will be exposed to cycling pressure stresses and weight bearing loads.

The optional support member is recessed a selected depth from the lip plane, and has a face 17, preferably planar, that is in substantially parallel orientation to the lip plane. Typically the face of the support member will be recessed at a depth of about 1 to about 5 mils (25 to 127 microns), preferably about 3 mils (75 microns). During use, when the vacuum effector is engaged with a work piece, the support member limits the degree to which a flexible work piece can deform or bend into the enclosed opening of the vaccum effector when the vacuum effector is actuated. The support member is configured such that it remains in a substantially parallel planar orientation to the lip plane.

Typically the support member 18 is dimensionally stable, i.e., sufficiently stiff that it will not deflect undesirably under pressure from the work piece when the effector is actuated. Illustrative examples of support members 18 include perforated metal or plastic plates, metal mesh, etc. Illustrative examples of suitable materials include aluminum, stainless steel, polyvinyl chloride, and styrene, etc.

Vaccum effectors of the invention utilize a negative pressure source to draw air through the enclosed opening, and thus draft or urge the work piece toward the enclosed opening such that it engages with the effector, typically spanning the opening and engaging the rim. The direction of the air flow in response to the negative pressure source is shown by arrows V in Figs. 2-4.

In some embodiments the negative pressure source comprises a vacuum pump. In some embodiments the negative pressure source comprises a Bernoulli device. Suitable negative pressure sources, capable of desired operating parameters, will be readily selectable by those skilled in the art.

When used, the vacuum effector and lifting location of the work piece are brought into close proximity and contact. Upon effect of the negative pressure, the vacuum effector and work piece engage, i.e., attain secure contact, whereby the vacuum effector can be used to manipulate the work piece in or through desired positions and/or spatial orientations. In the case of vacuum effectors using negative pressure sourced by vacuum, the vacuum effector is often placed in physical contact with the work piece and the negative pressure then actuated. In the case of vacuum effectors using negative pressure sourced by a Bernoulli device, the negative pressure is often already actuated as the vacuum effector is brought into close proximity to the work piece; as sufficiently close proximity is attained the work piece will move into contact with the vacuum effector under the influence of the negative pressure.

Once the work piece has been manipulated as desired, reduction or even cessation of the negative pressure will be used to release or disengage the work piece from the vacuum effector. For instance, in operations converting large sheets of optical films into smaller pieces such as by laser cutting, vacuum effectors of the invention may be used advantageously to position the large pieces of optical sheeting for laser cutting, to move the cut pieces from the cutting station to subsequent station such as packaging for shipment or installation on a device such as a handheld electronic device, a television, computer, etc.

Among the benefits of vacuum effectors of the invention is that they may be used to manipulate delicate work pieces. For instance, many products with electronic displays contain optical films that rely upon precisely arranged dimensions and configurations of multiple polymeric layers to provide desired optical benefits. Such optical films are easily damaged by scratching, gouging, bending, etc.

Vacuum effectors of the present invention have one and typically several features that make them well suited for use with such delicate work pieces.

Typically, the rim or lip of the wall will comprise a resilient, soft material such as rubber. The rim or lip of the wall has a dimensionally stable planar configuration such that a work piece having a planar lifting location can be supported stably thereby without being undesirably torqued or stressed. In use, the vacuum effector is preferably brought into contact with the lifting location of the work piece in a substantially parallel planar orientation, i.e., the lip plane and planar surface of the lifting location being substantially parallel to one another rather than at an angle, typically preferably with little or no relative lateral motion that results in slippage between the vacuum effector and the work piece. This minimizes the potential for imparting scratches or mechanical stresses to the work piece.

In accordance with the invention, the vacuum effector comprises a shroud covering the rim of the wall or at least that part of the rim and wall which comes in contact with the work piece during use. Such a shroud protects the portion of the work piece which is contacted by the rim during use of the vacuum effector.

In some preferred embodiments, the vacuum effector will comprise a permeable shroud that covers the rim of the wall and spans the enclosed opening. Such a shroud will provide similar protection to the portion of the work piece which is contacted, including, in addition, the portions of the work piece that may come into contact with the recessed face of the support member. Such contact can arise through the combination of compression of the rim portion of the wall and the extent, if any, by which the work piece flexes into the enclosed opening when the vacuum effector is used. By selection of the depth to which the support member is recessed from the lip plane, the maximum degree to which the work piece can be so flexed is controlled and minimized.

The shrouds are preferably securely mounted on the vacuum effector under slight radial tension as any tendency for them to slide between the lip of the wall and work piece may mar or otherwise damage the work piece or disrupt the necessary negative pressure.

Materials useful as the shroud in vacuum effectors of the present invention typically comprise, and may consist essentially of fibrous materials. Illustrative examples include fabrics having a base layer, e.g., woven, knitted, non-woven, or combination thereof, with a resilient looped pile protruding therefrom.

Illustrative examples of materials that could be used in the present invention have been disclosed in, e.g., PCT Patent Publication Nos. WO 2011/038279, entitled WEB CONVEYANCE METHOD AND APPARATUS USING SAME; WO 2011/038248, entitled METHOD FOR MAKING ENGAGMENT COVER FOR ROLLERS FOR WEB CONVEYANCE APPARATUS; and also in co-pending US Patent Application Serial Nos. 61/694,300, entitled ADAPTABLE WEB SPREADING DEVICE (Attorney Docket No. 70032US002, filed August 29, 2012), and 67/709430, entitled LOOPED PILE FILM ROLL CORE (Attorney Docket No. 69594US002, filed October 4, 2012).

In a typical embodiment, the shroud is made with a knit fabric having a pile-forming loop at every stitch. In an illustrative embodiment there are 25 stitches per inch (1 stitch per millimeter). The fibrous material(s) used to make the fabric may be single filament strands, multifilament strands (e.g., two or more strands wound together to yield a single thread), or combinations thereof.

In many embodiments, the looped pile has a loop height (i.e., dimension from the plane defined by the top of the base layer to the apex of the pile loops) of from about 0.4 to about 0.8 mm, preferably from about 0.5 to about 0.7 mm. It will be understood that shrouds having looped piles having loop heights outside this range may be used in certain embodiments. If the loop height is insufficient, the cover may fail to provide effective cushioning effect to the work piece to achieve the full benefits of the invention, resulting in damage to the work pieces. If the loop height is too high, the pile may tend to get floppy and undesirably affect stability of engagement of the work piece to the vacuum effector or damage the work piece.

The pile should be sufficiently dense to be supportive of the work piece during engagement, manipulation, and disengagement so as to reliably achieve the benefits of the disclosure. For instance, the looped pile comprises fibers selected to have an appropriate denier for the application, with thicker fibers providing relatively greater resistance to compression. Illustrative examples include fibers having a denier from about 100 to about 500. As will be understood, fibers having a denier outside this range may be used in some embodiments in accordance with the invention.

In illustrative embodiments, the fibers can be selected from the group consisting of poly(tetrafluoroethylene) (PTFE such as, e.g., TEFLON® fiber), aramid (e.g., KEVLAR®), polyester, polypropylene, nylon, wool, bamboo, cotton, or a combination thereof. However, those skilled in the art will be able to readily select other fibers which can be effectively knit and used in covers of the disclosure.

The base is typically knit so as to provide the desired properties to permit it to be placed on a vacuum effector and used in accordance with the disclosure, e.g., stretch and slide sufficiently easily over the rim to permit it to be installed while not stretching undesirably during operation.

Typically, because of the requirements of the knitting processes used to make them, knit fabrics are made using fibrous materials that have been treated with lubricants to facilitate the knitting process. When the resultant knit fabrics are used in the present invention, such lubricants may tend to wear away causing variation in frictional performance to the article and potential contamination issues. Accordingly, it is typically preferred to wash or scour fabrics used herein.

The material(s) selected should be compatible with the other vacuum effector components and the intended work piece materials and operating conditions, e.g., stable and durable under the ambient operating conditions, e.g., temperature, humidity, materials present, etc.

Illustrative examples of preferred shroud materials, particularly for use with Bernoulli-type vacuum effectors include knit materials having resilient looped piles which will provide desired high coefficient of friction with the work piece. In a typical embodiment, the cover is made with a knit fabric having a pile-forming loop at every stitch. In an illustrative embodiment there are 25 stitches per inch (1 stitch per millimeter). The fibrous material(s) used to make the fabric may be single filament strands, multifilament strands (e.g., two or more strands wound together to yield a single thread), or combinations thereof. In some embodiments, the looped pile has a loop height (i.e., dimension from the plane defined by the top of the base layer to the apex of the pile loops) of from about 0.4 to about 0.8 mm, preferably from about 0.5 to about 0.7 mm. It will be understood that shrouds having looped pile having loop heights outside this range may be used in certain embodiments. In illustrative embodiments, the fibrous material(s) are selected from the group consisting of poly(tetrafluoroethylene) (PTFE such as, e.g., TEFLON® fiber), aramid (e.g., KEVLAR®), polyester, polypropylene, nylon, or combinations thereof. Those skilled in the art will be able to readily select other fibers which can be effectively knit and used in covers of the invention.

Vacuum effectors of the invention can be used in a variety of locations, particularly where means for handling delicate work pieces without touching them by hand is desired. Vacuum effectors of the invention can be used as hand tools, e.g., on hand held wands with manually activated negative pressure, and can be used as component apparatus on automated equipment, e.g., industrial robots used in laser converting, handling, and installing optical films.

Illustrative examples of optical films with which vacuum effectors of the present invention include such films are disclosed in US Patent Nos. 5,175,030 (Lu et al.), 5,183,597 (Lu), 5,161,041 (Abileah), 5,828,488 (Ouderkirk et al.), 5,919,551 (Cobb et al.), 6,277,471 (Tang), 6,280,063 (Fong), 6,759,113 (Tang), 6,581,286 (Campbell et al.), 6,991,695 (Tait et al.), 7,269,327 (Tang), and 7,269,328 (Tang).

The method of the invention comprises: (a) providing a vacuum effector as described herein, (b) providing a work piece, (c) engaging said vacuum effector and said work piece, and (d) disengaging said vacuum effector and said work piece.

In most embodiments, the method will further comprise manipulating the work piece between the moment it is engaged by the vacuum effector and the moment it is disengaged by the vacuum effector. Depending upon the embodiment, manipulating the work piece will comprise one or more of: securing the location of the work piece, securing the orientation of the work piece, changing the location of the work piece, and changing the orientation of the work piece. In some applications, other operations will be carried out on the work piece as desired while it is engaged with the vacuum effector. For instance, depending upon application the work piece may be subjected to laser cutting, polishing, assembly with other articles, disassembly from other articles, packing, etc.

In accordance with the invention, such manipulations may be carried out upon delicate work pieces with surprising efficacy and minimal or no damage to the work piece.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention which is defined by the appended claims.

## Claims

1. A vacuum effector (10) comprising:
(a) a wall (12) defining an enclosed opening (14) and having a rim (16) defining a lip plane;
(b) a negative pressure source; and
(c) a shroud covering said rim, said shroud (20) comprising a fibrous material,
the vacuum effector being **characterized in that** said shroud (20) comprises a fabric having a base layer with a resilient looped pile protruding therefrom.

2. The vacuum effector of claim 1 wherein said shroud is permeable and spans said enclosed opening (14).

3. The vacuum effector of claim 1 wherein the shroud (20) comprises fibers selected from the group consisting of poly(tetrafluoroethylene), aramid, polyester, polypropylene, nylon, wool, bamboo, cotton, or a combination thereof.

4. The vacuum effector of claim 1 wherein said rim (16) comprises a resilient, compressible material.

5. The vacuum effector of claim 1 further comprising: (d) a permeable support member (18) spanning said enclosed opening (14), said support member (18) being recessed a selected depth from the lip plane.

6. The vacuum effector of claim 5 wherein the support member (18) comprises a face (17) that is substantially planar and is oriented substantially parallel to the lip plane.

7. The vacuum effector of claim 5 wherein the support member (18) is dimensionally stable so that it will not deflect under pressure when the effector (10) is actuated.

8. A method for manipulating a work piece, said method comprising:
(a) providing a vacuum effector (10) comprising:
(1) a wall (12) defining an enclosed opening (14) and having a rim (16) defining a lip plane;
(2) a negative pressure source; and
(3) a shroud (20) over said rim (16), said shroud comprising a fibrous material, wherein said shroud (20) comprises a fabric having a base layer with a resilient looped pile protruding therefrom;
(b) providing a work piece,
(c) engaging said vacuum effector (10) with said work piece, and
(d) disengaging said vacuum effector (10) from said work piece.

9. The method of claim 8 wherein said shroud (20) is permeable and spans said enclosed opening.

10. The method of claim 8 wherein the shroud (20) comprises fibers selected from the group consisting of poly(tetrafluoroethylene), aramid, polyester, polypropylene, nylon, wool, bamboo, cotton, or a combination thereof.

11. The method of claim 8 wherein said rim (16) comprises a resilient, compressible material.

12. The method of claim 8 wherein said vacuum effector (10) further comprises (4) a permeable support member (18) spanning said enclosed opening (14), said support member (18) being recessed at a selected depth from the lip plane.

13. The method of claim 12 wherein the support member (18) comprises a face (17) that is substantially planar and is oriented substantially parallel to the lip plane.

14. The method of claim 8 further comprising manipulating said work piece between said engaging and said disengaging.

15. The method of claim 12 wherein the support member (18) is dimensionally stable so that it will not deflect under pressure when the effector (10) is actuated.

## Patentansprüche

1. Vakuum-Effektor (10), der aufweist:
(a) eine Wand (12), die eine umschlossene Öffnung (14) definiert und einen Rand (16) aufweist, der eine Lippenebene definiert;
(b) eine Unterdruckquelle; und
(c) einen den Rand bedeckenden Kragen, wobei der Kragen (20) ein faseriges Material aufweist,
wobei der Vakuum-Effektor **dadurch gekennzeichnet ist, dass** der Kragen (20) ein Gewebe mit einer Grundschicht mit einem elastischen Schlingenflor aufweist, der aus dieser herausragt.

2. Vakuum-Effektor nach Anspruch 1, wobei der Kragen durchlässig ist und die umschlossene Öffnung (14) umspannt.

3. Vakuum-Effektor nach Anspruch 1, wobei der Kragen (20) ein Fasermaterial aufweist, das ausgewählt ist aus der Gruppe bestehend aus Poly(tetrafluorethylen), Aramid, Polyester, Polypropylen, Nylon, Wolle, Bambus, Baumwolle oder einer Kombination davon.

4. Vakuum-Effektor nach Anspruch 1, wobei der Rand (16) ein elastisches, komprimierbares Material aufweist.

5. Vakuum-Effektor nach Anspruch 1, ferner aufweisend: (d) ein durchlässiges Stützelement (18), das die umschlossene Öffnung (14) umspannt, wobei das Stützelement (18) um eine ausgewählte Tiefe aus der Lippenebene zurückgesetzt ist.

6. Vakuum-Effektor nach Anspruch 5, wobei das Stützelement (18) eine Fläche (17) aufweist, die im Wesentlichen planar und im Wesentlichen parallel zur Lippenebene ausgerichtet ist.

7. Vakuum-Effektor nach Anspruch 5, wobei das Stützelement (18) formstabil ist, sodass es sich unter Druck nicht durchbiegt, wenn der Effektor (10) betätigt wird.

8. Verfahren zum Manipulieren eines Werkstücks, wobei das Verfahren aufweist:
(a) Bereitstellen eines Vakuum-Effektors (10), der aufweist:
(1) eine Wand (12), die eine umschlossene Öffnung (14) definiert und einen Rand (16) aufweist, der eine Lippenebene definiert;
(2) eine Unterdruckquelle; und
(3) einen Kragen (20) über dem Rand (16), wobei der Kragen ein faseriges Material aufweist, wobei der Kragen (20) ein Gewebe mit einer Grundschicht mit einem elastischen Schlingenflor aufweist, der aus dieser herausragt;
(b) Bereitstellen eines Werkstücks,
(c) Eingreifen des Vakuum-Effektors (10) in das Werkstück, und
(d) Lösen des Vakuum-Effektors (10) vom Werkstück.

9. Verfahren nach Anspruch 8, wobei der Kragen (20) durchlässig ist und die umschlossene Öffnung umspannt.

10. Verfahren nach Anspruch 8, wobei der Kragen (20) ein Fasermaterial aufweist, das ausgewählt ist aus der Gruppe bestehend aus Poly(tetrafluorethylen), Aramid, Polyester, Polypropylen, Nylon, Wolle, Bambus, Baumwolle oder einer Kombination davon.

11. Verfahren nach Anspruch 8, wobei der Rand (16) ein elastisches komprimierbares Material aufweist.

12. Verfahren nach Anspruch 8, wobei der Vakuum-Effektor (10) ferner (4) ein durchlässiges Stützelement (18) aufweist, das die umschlossene Öffnung (14) umspannt, wobei das Stützelement (18) um eine ausgewählte Tiefe aus der Lippenebene zurückgesetzt ist.

13. Verfahren nach Anspruch 12, wobei das Stützelement (18) eine Fläche (17) aufweist, die im Wesentlichen planar und im Wesentlichen parallel zur Lippenebene ausgerichtet ist.

14. Verfahren nach Anspruch 8, ferner aufweisend das Manipulieren des Werkstücks zwischen dem Eingreifen und dem Lösen.

15. Verfahren nach Anspruch 12, wobei das Stützelement (18) formstabil ist, sodass es sich unter Druck nicht durchbiegt, wenn der Effektor (10) betätigt wird.

## Revendications

1. Actionneur de vide (10) comprenant :
(a) une paroi (12) définissant une ouverture encastrée (14) et ayant un rebord (16) définissant un plan de lèvre ;
(b) une source de pression négative ; et
(c) un carénage couvrant ledit rebord, ledit carénage (20) comprenant un matériau fibreux,
l'actionneur de vide étant **caractérisé en ce que** ledit carénage (20) comprend un tissu ayant une couche de base avec un poil bouclé élastique faisant saillie de celui-ci.

2. Actionneur de vide selon la revendication 1 dans lequel ledit carénage est perméable et englobe ladite ouverture encastrée (14).

3. Actionneur de vide selon la revendication 1 dans lequel le carénage (20) comprend des fibres choisies dans le groupe constitué de poly(tétrafluoroéthylène), aramide, polyester, polypropylène, nylon, laine, bambou, coton, ou une combinaison de ceux-ci.

4. Actionneur de vide selon la revendication 1 dans lequel ledit rebord (16) comprend un matériau compressible élastique.

5. Actionneur de vide selon la revendication 1 comprenant en outre : (d) un élément de support perméable (18) englobant ladite ouverture encastrée (14), ledit élément de support (18) étant en retrait sur une profondeur choisie par rapport au plan de lèvre.

6. Actionneur de vide selon la revendication 5 dans lequel l'élément de support (18) comprend une face (17) qui est essentiellement plane et est orientée essentiellement parallèle au plan de lèvre.

7. Actionneur de vide selon la revendication 5 dans lequel l'élément de support (18) est dimensionnellement stable de sorte qu'il ne s'infléchira pas sous pression lorsque l'actionneur (10) est actionné.

8. Procédé pour manipuler une pièce à usiner, ledit procédé comprenant :
(a) la fourniture d'un actionneur de vide (10) comprenant :
(1) une paroi (12) définissant une ouverture encastrée (14) et ayant un rebord (16) définissant un plan de lèvre ;
(2) une source de pression négative ; et
(3) un carénage (20) par-dessus ledit rebord (16), ledit carénage comprenant un matériau fibreux, dans lequel ledit carénage (20) comprend un tissu ayant une couche de base avec un poil bouclé élastique faisant saillie de celui-ci ;
(b) la fourniture d'une pièce à usiner,
(c) la mise en prise dudit actionneur de vide (10) avec ladite pièce à usiner, et
(d) la libération dudit actionneur de vide (10) par rapport à ladite pièce à usiner.

9. Procédé selon la revendication 8 dans lequel ledit carénage (20) est perméable et englobe ladite ouverture encastrée.

10. Procédé selon la revendication 8 dans lequel le carénage (20) comprend des fibres choisies dans le groupe constitué de poly(tétrafluoroéthylène), aramide, polyester, polypropylène, nylon, laine, bambou, coton, ou une combinaison de ceux-ci.

11. Procédé selon la revendication 8 dans lequel ledit rebord (16) comprend un matériau compressible élastique.

12. Procédé selon la revendication 8 dans lequel ledit actionneur de vide (10) comprend en outre (4) un élément de support perméable (18) englobant ladite ouverture encastrée (14), ledit élément de support (18) étant en retrait à une profondeur choisie par rapport au plan de lèvre.

13. Procédé selon la revendication 12 dans lequel l'élément de support (18) comprend une face (17) qui est essentiellement plane et est orientée essentiellement parallèle au plan de lèvre.

14. Procédé selon la revendication 8 comprenant en outre la manipulation de ladite pièce à usiner entre ladite mise en prise et ladite libération.

15. Procédé selon la revendication 12 dans lequel l'élément de support (18) est dimensionnellement stable de sorte qu'il ne s'infléchira pas sous pression lorsque l'actionneur (10) est actionné.
